# FASCICULE DE BREVET EUROPEEN

(11) **EP 3 202 708 B1**
(45) Date de publication et mention de la délivrance du brevet: **03.05.2023**
(21) Numéro de dépôt: 16154126.3
(22) Date de dépôt: 03.02.2016
(51) Int. Cl.: B81C 99/00, G04B 13/02

(54) **PROCÉDÉ DE FABRICATION D'UN COMPOSANT HORLOGER HYBRIDE**
VERFAHREN ZUR HERSTELLUNG EINER HYBRID-UHRENKOMPONENTE
METHOD FOR MANUFACTURING A HYBRID CLOCK COMPONENT

(43) Date de publication de la demande: 09.08.2017
(73) Titulaire: ROLEX SA, 1211 Genève 26 (CH)
(72) Inventeur: BOSSART, Richard, 1616 Attalens (CH); CALAME, Florian, 1066 Epalinges (CH)
(74) Mandataire: Moinas & Savoye SARL

(56) Documents cités:
- EP-A2- 1 932 804
- CH-A1- 706 645
- JP-A- 2012 167 808

## Description

La présente invention concerne un procédé de fabrication d'un composant horloger hybride, comprenant au moins deux matériaux différents. Elle porte aussi sur un composant horloger en tant que tel obtenu selon ce procédé, un mouvement de pièce d'horlogerie et une pièce d'horlogerie comprenant un tel composant horloger hybride.

Il est connu de fabriquer des composants horlogers hybrides composés par exemple d'une première partie en silicium, ou plus généralement en tout matériau micro-usinable, et d'une seconde partie en métal. Un procédé de fabrication d'un tel composant horloger hybride utilise un premier procédé de fabrication par micro-usinage, notamment par gravure ionique réactive profonde (acronyme DRIE en anglais), pour former la première partie, et un second procédé de fabrication basé sur l'électroformage, notamment connu par l'acronyme LIGA, pour faire croître la seconde partie en métal. Cette seconde partie métallique peut être rapportée a posteriori, mais il est plus précis de la faire croître directement en combinaison avec la première partie en silicium.

Le document EP1932804 décrit par exemple une méthode de fabrication d'un tel composant horloger hybride qui comprend la gravure d'une plaque de silicium placée sur un substrat de travail, sur laquelle sera ensuite déposée une couche de résine photosensible (photoresist) formant un moule pour la croissance d'une couche de métal électroformée. La plaque en silicium comporte au moins une cavité traversante qui est aussi comblée par le métal électroformé. Cette technique apporte l'avantage de garantir la précision de positionnement des deux matériaux distincts du composant horloger. Il en résulte donc un composant horloger qui comprend un premier niveau partiellement en silicium et partiellement en métal et un second niveau en métal, superposé sur la surface supérieure du premier niveau. Une liaison dite intime entre les deux matériaux distincts du composant obtenu est assurée par la croissance de la partie métallique le long des flancs du silicium, au niveau de la cavité traversante du premier niveau. Toutefois, cette liaison n'est ni chimique, ni mécaniquement résistante, car elle ne repose que sur la seule rugosité de ces flancs, ce qui peut s'avérer trop faible pour assurer la cohésion de l'ensemble lorsqu'il est soumis à certaines contraintes ou à une variation de température importante. Ainsi, les composants horlogers ainsi obtenus présentent un risque de décohésion entre les deux matériaux, c'est-à-dire au niveau de la liaison entre le métal et le silicium.

Pour pallier ces inconvénients, le document WO2009062943 décrit un procédé de fabrication d'un composant hybride silicium - métal, caractérisé en ce que la partie métallique enserre la partie en silicium « en sandwich ». Pour cela, le procédé de fabrication met en oeuvre deux étapes distinctes de croissance de la partie métallique, respectivement sur chaque surface supérieure et inférieure de la partie en silicium. Cette approche améliore la cohésion entre les deux parties du composant horloger en matériaux différents. Toutefois, elle nécessite la mise en oeuvre d'un procédé de fabrication complexe, notamment du fait de l'obligation de retourner le substrat pour réaliser la croissance sur la surface inférieure de la partie en silicium. En complément, on constate de plus une faiblesse au niveau de l'interface entre les différentes couches distinctes de métal formées par les deux étapes distinctes de croissance de la partie métallique.

Le document CH706645 décrit un autre procédé pour fabriquer un composant horloger hybride. Ce composant comprend une plaque avec une ouverture dans laquelle la surface intérieur est métallisée de sorte que la plaque est apte pour le chassage par une axe. Dans le procédé de fabrication une plaque ayant une ouverture est recouverte avec une couche de métal formée par électroformage et s'étendant au travers de l'ouverture et sur les deux surfaces entières de la plaque. Ensuite la forme finale de la pièce métal est réalisée par gravure pour éliminer les régions métalliques superflus tout en maintenant des régions métalliques circulaires autour de l'ouverture sur les deux surfaces.

Ainsi, la présente invention a pour objet d'améliorer la fabrication d'un composant horloger hybride. Notamment, cette invention s'applique à la fabrication de tout composant horloger comprenant une première partie dans un premier matériau, de préférence micro-usinable, et une seconde partie dans un second matériau différent, en métal.

Plus précisément, un premier objet de l'invention est de permettre d'atteindre une cohésion et une résistance mécanique satisfaisante d'un composant horloger hybride.

Un second objet de l'invention est de proposer un procédé de fabrication simple d'un composant horloger hybride.

L'invention est plus particulièrement définie par les revendications.

Ces objets, caractéristiques et avantages de la présente invention seront exposés en détail dans la description suivante de modes de réalisation particuliers faits à titre non-limitatif en relation avec les figures jointes parmi lesquelles :
Les figures 1a à 1g illustrent les étapes successives d'un procédé de fabrication d'un composant horloger hybride selon un mode de réalisation de l'invention.
Les figures 2a à 2g illustrent les étapes successives d'un procédé de fabrication d'un composant horloger hybride selon une variante du mode de réalisation de l'invention.
Les figures 3a à 3g illustrent les étapes successives d'un procédé de fabrication d'un composant horloger hybride selon une deuxième variante du mode de réalisation de l'invention
Les figures 4 à 9 illustrent différents composants horlogers hybrides obtenus par un procédé de fabrication selon un mode de réalisation de l'invention.

Pour une raison de simplification, nous utiliserons les termes « métal » et « métallique » dans la description suivante pour désigner un matériau métallique ou un alliage métallique. De plus, les mêmes références seront utilisées pour des éléments identiques ou similaires dans les différentes variantes de réalisation de l'invention.

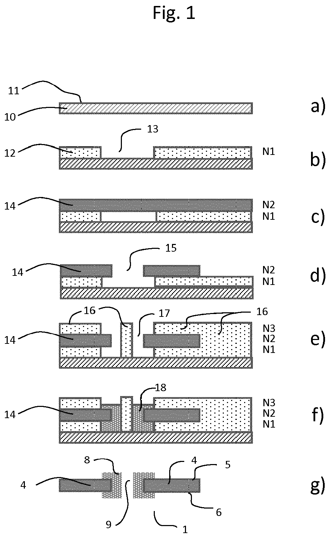

La figure 1a illustre une première étape du procédé de fabrication d'un composant horloger hybride selon le mode de réalisation de l'invention. Cette étape consiste à se munir d'un substrat 10 de travail qui servira de support à la fabrication du composant horloger. Ce substrat est destiné à être retiré, c'est-à-dire qu'il ne fait pas partie du composant horloger final. Il est soit en métal ou en tout matériau conducteur, soit formé à base d'un matériau non conducteur, dont la surface supérieure 11 est rendue conductrice par métallisation. Ainsi, le substrat de travail peut être constitué d'une plaque de silicium comportant une couche métallique obtenue par dépôt PVD, par électroformage, d'une plaque de silicium dopé ou d'une plaque métallique ou par tout autre substrat plat dont la surface supérieure conduit le courant électrique.

La construction du composant horloger va être réalisée à l'aide d'un empilement de couches dans une direction sensiblement perpendiculaire à la surface supérieure 11 du substrat 10, que nous appellerons par convention direction verticale z, orientée vers le haut sur les figures. Ce substrat 10 plan définit de même par convention un plan horizontal.

La figure 1b illustre la seconde étape du procédé de fabrication d'un composant horloger hybride qui consiste à déposer et structurer une première couche 12 de résine photosensible afin de former la partie inférieure du moule destiné à contrôler la croissance inférieure de la partie métallique du composant horloger hybride.

De manière connue, la résine est une résine photosensible, adaptée à la photolithographie. La résine peut être négative ou positive. Dans le premier cas, elle est conçue pour devenir insoluble ou difficilement soluble à un révélateur sous l'action d'un rayonnement, alors que, dans le second cas, elle est conçue pour devenir soluble à un révélateur sous l'action d'un rayonnement, alors que la partie non exposée au rayonnement reste insoluble ou difficilement soluble. Dans l'exemple particulier du mode de réalisation, la résine utilisée peut être de type « SU-8 », qui est une résine photosensible négative qui polymérise sous l'action d'un rayonnement UV. Une étape de photolithographie de la couche initiale de résine est réalisée, qui consiste à exposer à une radiation lumineuse ou insoler la couche initiale de résine à travers un masque comprenant des ouvertures et des zones opaques. Ce masque définit le motif à reproduire pour la réalisation du premier niveau du composant à fabriquer. Les radiations lumineuses utilisées pour irradier ou insoler la résine sont ici des rayonnements UV émis par une source UV. Les rayonnements sont perpendiculaires au plan dans lequel s'étend le masque de manière à n'irradier que les zones de la résine situées au droit des ouvertures ménagées dans le masque. Dans l'exemple de réalisation particulier décrit ici, les zones de résine insolées deviennent insensibles ou insolubles à la plupart des liquides de développement. L'étape précédente d'exposition à des radiations lumineuses est suivie optionnellement d'une étape de traitement thermique de réticulation, puis d'une étape de développement. Le développement consiste à éliminer les zones de résine non exposées selon un procédé adapté à la résine utilisée, par exemple par dissolution avec un produit chimique ou par un procédé plasma. Après dissolution, la surface supérieure 11 conductrice du substrat 10 apparaît au moins sur une zone du moule 13 où la résine a été éliminée. Toute autre méthode de l'état de la technique permettant de former un moule peut en variante être utilisée.

A l'issue de cette étape, on obtient donc le moule 13 et la structure illustrée par la figure 1b, dans laquelle la surface supérieure 11 conductrice du substrat 10 est recouverte d'un moule 13 en résine sur une couche formant un premier niveau N1. Avantageusement, la première couche de résine photosensible est d'épaisseur (hauteur dans la direction z par convention) identique à l'épaisseur souhaitée pour la partie inférieure de la partie métallique du composant horloger hybride.

L'étape suivante, illustrée par la figure 1c, consiste à déposer sur cette première couche 12 de résine photosensible formant le moule 13 sur le niveau N1 une plaque 14 de silicium, formant un second niveau N2 de la structure, superposé au niveau N1. Cette plaque 14 de silicium est destinée à former une première partie en un premier matériau du composant horloger hybride final.

Ensuite, le procédé met en oeuvre une étape de structuration de la plaque 14 de silicium, par gravure DRIE par exemple, de manière à former au moins une ouverture traversante 15 au moins partiellement superposée à une zone 13 sans résine du premier niveau N1. En remarque, la surface supérieure 11 du substrat 10 reste donc accessible par cette au moins une ouverture traversante 15 de la plaque en silicium. La figure 1d illustre le résultat obtenu par cette étape. En remarque, l'ouverture traversante 15 est idéalement moins étendue dans au moins une direction donnée que la zone sans matière au-dessus de laquelle elle est formée, pour favoriser la cohésion du composant final qui sera formé, comme cela sera précisé par la suite. Autrement dit, la surface inférieure de la plaque 14 recouvre au moins une partie d'une zone 13 sans résine de premier niveau N1.

Le procédé met ensuite en oeuvre une étape consistant à déposer et structurer une deuxième couche 16 de résine photosensible, formant un troisième niveau N3 au-dessus de la surface supérieure de la plaque 14 en silicium et remplissant éventuellement au moins une partie d'au moins une ouverture traversante 15 de la plaque 14. La figure 1e illustre un exemple de résultat obtenu par cette étape, qui consiste à former un moule 17, s'étendant donc en partie sur le niveau N3 sur la surface supérieure de la plaque 14 en silicium, et en partie (de manière optionnelle) à l'intérieur des ouvertures traversantes 15 de la plaque en silicium, jusqu'à la surface supérieure 11 du substrat. Ce moule 17 est donc formé par la combinaison du moule 13 du niveau N1, l'ouverture traversante 15 du niveau N2 et une zone sans matière au moins en partie superposée du niveau N3. Il s'étend depuis la surface supérieure 11 du substrat 10 jusqu'à la surface supérieure du niveau N3. Dans l'exemple illustré, l'ouverture traversante 15 est cylindrique, et la couche 16 présente une partie cylindrique de plus petit diamètre disposé au centre du cylindre formé par l'ouverture traversante 15, laissant un anneau vide sur son pourtour formant une partie annulaire du moule 17. Au niveau N3, le moule 16 laisse idéalement au moins une surface de la plaque 14 apparente au niveau d'une ouverture traversante 15, directement sur un abord de cette ouverture traversante 15.

Le procédé met ensuite en oeuvre une étape qui consiste à électrodéposer un métal dans le moule constitué par les différentes couches de résine photosensible et la partie en silicium du composant horloger hybride. Cette croissance de métal, destinée à former une seconde partie en un second matériau du composant horloger hybride final, est poursuivie au moins en partie sur le niveau N3. Le résultat est illustré sur la figure 1f. Il apparait donc que le métal électroformé 18 forme une partie d'un seul tenant qui s'étend depuis la surface supérieure 11 du substrat 10 jusqu'à la couche de niveau N3, au-dessus de la plaque en silicium. Le métal s'étend notamment à la fois sur la surface inférieure et sur la surface supérieure de la plaque 14, tout en la traversant par une ouverture traversante 15, ce qui forme une structure sandwich à l'aide d'une partie métallique d'un seul tenant formée par une seule et même étape d'électroformage. Le composant horloger comprend donc une première couche sur un premier niveau N1 ne comprenant que du métal, une seconde couche sur un second niveau N2 comprenant du métal et du silicium, et une troisième couche sur un troisième niveau N3 ne comprenant que du métal.

Enfin, le procédé met en oeuvre une dernière étape de libération du composant horloger hybride de son support, c'est-à-dire le substrat 10, qui permet d'obtenir le composant horloger hybride 1 illustré par la figure 1g, formé par une partie en silicium 4 provenant de la plaque 14 de silicium utilisée et une partie en métal 8 provenant du métal électroformé 18. En complément, les résines utilisées ont été supprimées, de manière connue, avant ou après le retrait du substrat 10.

L'invention porte aussi sur un tel composant horloger hybride obtenu par ce procédé de fabrication. Un tel composant comprend donc une première partie 4 dans un premier matériau, par exemple du silicium ou tout autre matériau micro-usinable, et une seconde partie en métal. Cette seconde partie 8 forme une zone continue qui s'étend sur la surface supérieure 5 de la première partie 4, traverse la première partie 4 sur toute son épaisseur puis s'étend sur la surface inférieure 6 de ladite première partie 4. Il en résulte que la première partie 4 est emprisonnée entre deux portions de la seconde partie 8, ce qui garantit le maintien mécanique entre les deux parties. D'autre part, la seconde partie 8 est obtenue d'un seul tenant, ce qui garantit sa résistance maximale tout en permettant sa formation simple par une seule étape d'électroformage. Selon le mode de réalisation illustré, le composant horloger comprend de plus une ouverture traversante cylindrique 9 au sein de la seconde partie 8, ce qui permet d'insérer un axe de rotation par exemple, ou de former un insert métallique pour le chassage du composant horloger hybride.

La première partie du composant horloger hybride peut être dans tout matériau micro-usinable comme par exemple le silicium, le diamant, le quartz ou une céramique. En variante, le matériau micro-usinable utilisé peut être constitué de deux ou plusieurs couches, ou de plusieurs plaques superposées les unes aux autres comme par exemple une plaque de silicium dite SOI.

De plus, le composant horloger hybride peut comporter plus de deux parties, au moins un troisième partie en un troisième matériau distinct des deux matériaux, qui peut être un matériau micro-usinable ou un métal électroformé, associé à l'architecture de manière similaire aux deux premiers matériaux.

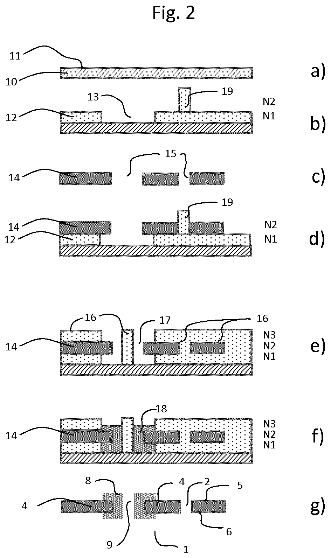

Les figures 2a à 2f illustrent une variante de réalisation, dans laquelle seules les différences vont être explicitées.

Selon cette variante du procédé, la seconde étape de formation d'un moule 13 de niveau N1 est suivie de la réalisation d'une seconde couche 19 de résine de niveau N2, directement superposée au niveau N1, pour atteindre le résultat illustré par la figure 2b. Cette seconde couche 19 permet avantageusement de réaliser des goupilles de positionnement.

Ensuite et comme illustré par la figure 2c, la plaque 14 en silicium est structurée de manière indépendante, par exemple par une méthode DRIE, pour former des ouvertures traversantes 15, dont au moins une correspondant à une goupille de positionnement et au moins une destinée à être superposée à une zone 13 sans résine du moule de premier niveau N1. En remarque, cette plaque structurée peut subir d'autres traitements, comme un traitement par oxydation, par dopage ou par toute autre technique (nitruration, recuit, avec couche ALD, CVD) visant à lui conférer les propriétés requises. La plaque structurée est ensuite associée à la structure précédemment formée comme illustré à la figure 2c, de sorte qu'une ouverture traversante soit traversée par une goupille de positionnement. Cette architecture garantit un positionnement précis de la plaque de silicium sur le niveau N2, comme représenté par la figure 2d, notamment un bon alignement et une superposition précise de son (ou de ses) ouverture traversante 15 au-dessus d'une zone 13 sans matière du premier niveau N1. En remarque, la plaque 14 en silicium est ainsi maintenue par la résine, tant de manière verticale par la première couche de résine de niveau N1 qu'horizontalement par au moins une goupille de positionnement en résine formé par la couche 19. Naturellement, il est aussi possible en option d'ajouter des structurations (traitement, micro-usinage) complémentaires à la plaque 14 de silicium après sa disposition sur le niveau N2 de l'architecture précédente.

Les étapes suivantes, illustrées par les figures 2e à 2g correspondent respectivement aux étapes illustrées par les figures 1e à 1g décrites précédemment.

Le composant horloger hybride obtenu, représenté par la figure 2g, se présente de manière très similaire à celui illustré par la figure 1g. Il comprend de plus une ouverture traversante 2 formée uniquement dans la première partie 4.

Le procédé de fabrication décrit par les deux variantes de réalisation précédentes peut comprendre d'autres variantes de réalisation.

Par exemple, le procédé peut comprendre une étape intermédiaire de métallisation entre deux étapes décrites précédemment, de manière à former une couche électriquement conductrice sur les surfaces non conductrices de résine et/ou de silicium, pour assurer une déposition correcte du métal, par exemple sur les épaulements.

Selon une autre variante, les étapes de déposition et structuration de résine photosensible peuvent être multiples au sein d'une même étape, afin de créer des moules de forme plus complexe et finalement un composant de structure plus complexe.

En variante, il est possible d'ajouter une ou plusieurs autres couches de résine pour obtenir une structure plus complexe.

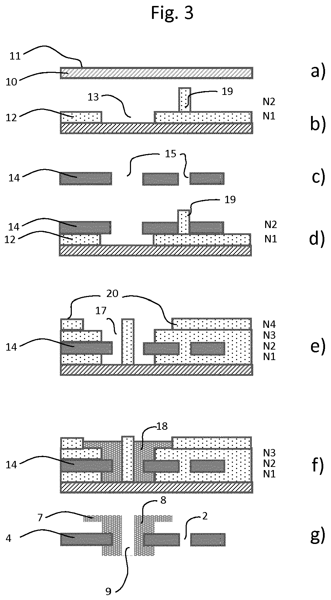

A cet effet, Les figures 3a à 3g illustrent une seconde variante de réalisation du procédé de fabrication, dans laquelle seules les différences vont être explicitées.

Les premières étapes relatives aux figures 3a à 3d correspondent aux étapes relatives aux figures 2a à 2d de la variante précédemment décrite.

Ensuite, le procédé comprend la disposition et structuration d'une couche 16 de résine sur un niveau N3 puis la disposition et structuration d'une couche 20 supplémentaire de résine sur un niveau N4, formant un moule 17 s'étendant sur quatre niveaux N1 à N4 au lieu de trois dans la variante précédente.

L'étape suivante d'électrodéposition, dont le résultat est illustré par la figure 3f, s'apparente à celle réalisée en référence à la figure 2f, mais sur un niveau supplémentaire N4.

Le composant horloger hybride obtenu, représenté par la figure 3g, se différencie des composants précédents en ce qu'il comprend une structure en métal 7, par exemple de type roue, non en contact direct avec la partie en silicium 4 du composant horloger, tout en présentant une cohésion totale. Cette seconde variante permet ainsi un partage des deux parties du composant horloger (par exemple silicium/roue métallique).

Il est évidemment également possible de structurer la première couche de résine directement déposée sur le substrat des réalisations en deux (ou plus) couches distinctes, de manière analogue.

Le procédé de fabrication décrit précédemment peut être utilisé pour la fabrication de composants horlogers tels que, à titre d'exemples illustratifs et non limitatifs, une ancre, un sautoir, une roue, un pignon, un râteau, un ressort, un balancier, une came, ou encore un pont.

L'invention porte aussi sur un composant horloger hybride obtenu par le procédé décrit précédemment, ainsi que sur un mouvement horloger et une pièce d'horlogerie, par exemple une montre-bracelet, comprenant un tel composant horloger hybride.

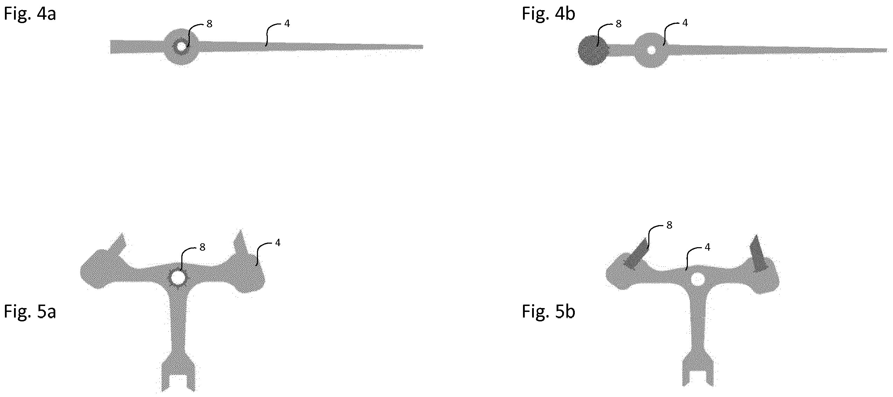

Ce dernier peut être une aiguille avec insert métallique pour le chassage, comme représenté par la figure 4a, ou une aiguille avec contrepoids pour équilibrage, comme représenté par la figure 4b.

Le composant horloger hybride peut être une ancre avec insert métallique pour le chassage, comme représenté par la figure 5a, ou une ancre avec palettes métalliques, comme représenté par la figure 5b.

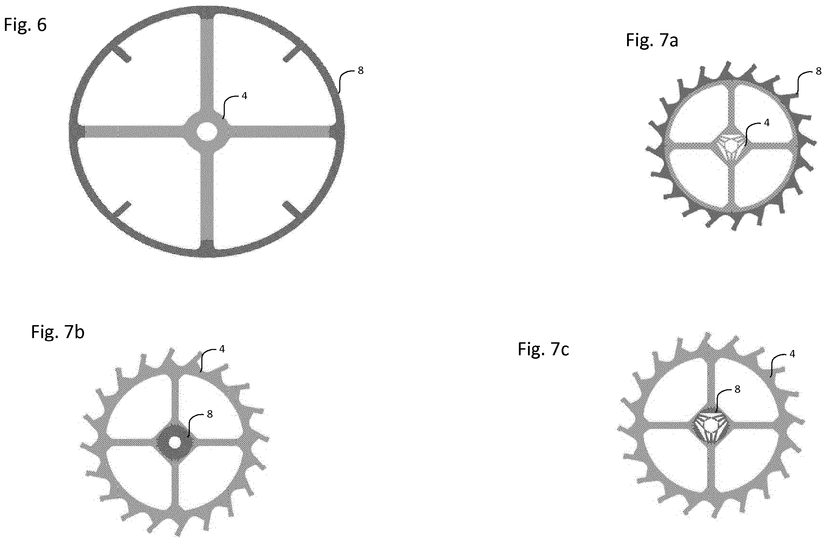

Le composant horloger hybride peut être un balancier avec un rapport inertie/poids optimisé comme représenté par la figure 6.

Le composant horloger hybride peut être une roue d'ancre avec dents métalliques comme représenté par la figure 7a, une roue d'ancre avec insert métalliques comme représenté par la figure 7b, ou une roue d'ancre avec structure métallique flexible comme représenté par la figure 7c.

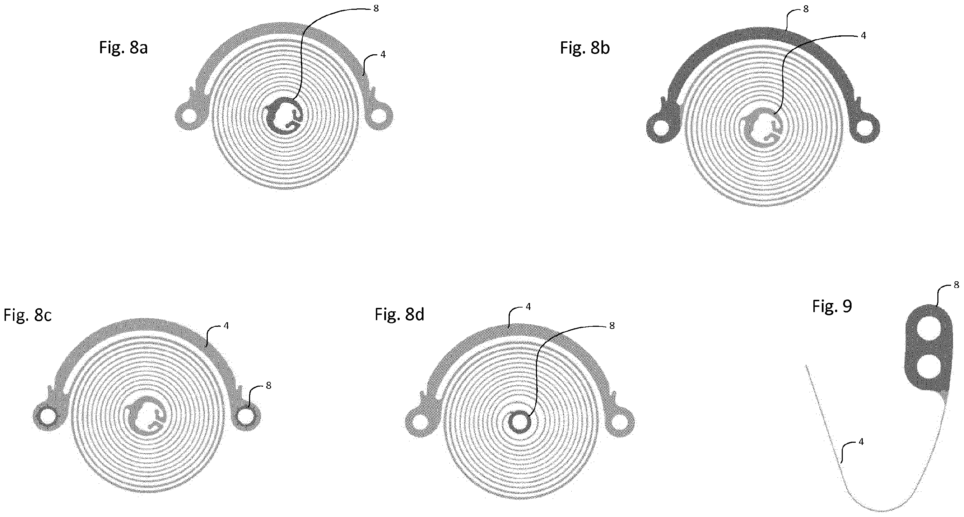

Le composant horloger hybride peut être un spiral avec virole flexible métallique comme représenté par la figure 8a, un spiral avec un porte-spiral en métal qui est prévu pour permettre la fixation de l'extrémité extérieure du spiral ou un système de pitonnage en métal, comme représenté par la figure 8b, un spiral avec inserts métalliques pour le chassage sur le porte-spiral comme représenté par la figure 8c, un spiral avec insert métallique pour le chassage à la virole comme représenté par la figure 8d. La fabrication d'un tel spiral utilise la variante du procédé de fabrication décrit précédemment, réalisant une structuration préalable et indépendante d'une plaque en silicium oxydé, notamment pour former les spires qui sont avantageusement réalisées en silicium oxydé afin de leur conférer les performances optimales.

Le composant horloger hybride peut être un ressort avec la partie fonctionnelle en silicium et la partie d'attache en métal comme représenté par la figure 9.

## Revendications

1. Procédé de fabrication d'un composant horloger hybride, 2. comprenant les étapes suivantes :
- se munir d'un substrat (10) dont au moins la surface supérieure (11) est conductrice ;
- former un moule (13) en résine au-dessus de la surface supérieure (11) du substrat (10), le moule (13) comprenant au moins une zone sans matière au-dessus du substrat (10) ;
- structurer au moins une plaque (14) d'un premier matériau micro-usinable de sorte à former au moins une ouverture traversante (15) au sein de la plaque (14), ladite plaque (14) structurée étant destinée à former une première partie (4) du composant horloger hybride, et disposer la au moins une plaque (14) au-dessus du moule (13) en résine formé à l'étape précédente ou inversement, disposer au moins une plaque (14) d'un premier matériau micro-usinable au-dessus du moule (13) en résine formé à l'étape précédente et structurer la au moins une plaque (14), de sorte à former au moins une ouverture traversante (15) de la au moins une plaque (14), la au moins une ouverture traversante (15) étant au moins partiellement superposée à une zone sans matière du moule (12) en résine formé à l'étape précédente ;
- former un moule (17) en résine au-dessus de la plaque (14), comprenant des zones sans matière s'étendant depuis la surface supérieure (11) du substrat (10) jusqu'à la surface supérieure de l'empilement, notamment au niveau d'une ouverture traversante (15) de la plaque (14) ;
- Déposer un métal ou un alliage par électroformage de sorte que le métal s'étende au travers l'ouverture traversante (15) et sur les deux faces supérieure et inférieure de la plaque (14), depuis la surface supérieure (11) du substrat (10) jusqu'au-dessus de la plaque (14), de sorte que le métal s'étende d'un seul tenant résultant d'une même étape d'électroformage, le métal électroformé étant destiné à former une seconde partie (8) du composant horloger hybride ;
- libérer le composant horloger hybride par le retrait du substrat (10) ;
- supprimer les moules en résines (13, 17) avant ou après le retrait du substrat (10).

2. Procédé de fabrication d'un composant horloger hybride selon la revendication précédente, comprenant les étapes complémentaires suivantes :
- former au moins une ouverture traversante (15) dans la au moins une plaque (14) superposée à une zone sans matière du moule (13) en résine de sorte que la face inférieure de la plaque (14) recouvre au moins partiellement la zone sans matière du moule (13) ; et
- former un moule (17) en résine au-dessus de la plaque (14) qui laisse libre au moins une partie de la surface supérieure de la plaque (14) au niveau d'une ouverture traversante (15) de la plaque (14).

3. Procédé de fabrication d'un composant horloger hybride selon la revendication 1 ou 2, comprenant une étape de formation d'une seconde couche (19) en résine au-dessus du moule (13) en résine formé au-dessus de la surface supérieure (11) du substrat (10), la seconde couche (19) formant au moins une goupille de positionnement permettant la disposition postérieure d'une plaque (14) structurée dont une ouverture traversante vient coopérer avec une goupille de positionnement pour assurer son maintien horizontal.

4. Procédé de fabrication d'un composant horloger hybride selon l'une des revendications 1 à 3, dans lequel le substrat (10) est constitué d'une plaque de silicium comportant une couche métallique, notamment obtenue par dépôt PVD, par électroformage, ou d'une plaque de silicium dopé ou d'une plaque métallique.

5. Procédé de fabrication d'un composant horloger hybride selon l'une des revendications précédentes, dans lequel l'étape consistant à former un moule (13) en résine au-dessus de la surface supérieure (11) du substrat (10) forme un moule (13) dont l'épaisseur correspond à la hauteur de métal disposée sur la face inférieure (6) de la première partie (4) du composant horloger hybride.

6. Procédé de fabrication d'un composant horloger hybride selon l'une des revendications précédentes, dans lequel le composant horloger hybride fait partie du groupe comportant une aiguille, une ancre, un balancier, un pignon, une roue d'ancre, un spiral, un ressort.

7. Procédé de fabrication d'un composant horloger hybride selon l'une des revendications précédentes, dans lequel l'étape consistant à déposer un métal ou un alliage par électroformage forme une deuxième partie du composant horloger qui comprend une ouverture traversante cylindrique (9), pour former un insert métallique apte à recevoir un axe de rotation ou pour le chassage du composant horloger hybride.

8. Procédé de fabrication d'un composant horloger hybride selon la revendication 6 ou 7, dans lequel le composant horloger hybride est :
- une aiguille avec insert métallique pour le chassage, ou
- une aiguille avec contrepoids pour équilibrage, ou
- une ancre avec insert métallique pour le chassage, ou
- une ancre avec palettes métalliques, ou
- un balancier avec un rapport inertie/poids optimisé, ou
- une roue d'ancre avec insert métalliques, ou
- une roue d'ancre avec structure métallique flexible, ou
- un spiral avec virole flexible métallique, ou
- un spiral avec porte-spiral en métal, ou
- un spiral avec inserts métalliques pour le chassage sur un porte-spiral, ou
- un spiral avec insert métallique pour le chassage à la virole, ou
- un ressort avec la partie fonctionnelle en silicium et la partie d'attache en métal.

## Patentansprüche

1. Verfahren zur Herstellung einer Hybrid-Uhrenkomponente, umfassend die folgenden Schritte:
- Beschaffen eines Substrats (10), von dem mindestens die obere Fläche (11) leitfähig ist;
- Bilden einer Form (13) aus Harz über der oberen Fläche (11) des Substrats (10), wobei die Form (13) mindestens einen Bereich ohne Material über dem Substrat (10) umfasst;
- Strukturieren mindestens einer Platte (14) eines mikrobearbeitbaren Werkstoffs, so dass mindestens eine durchgehende Öffnung (15) in der Platte (14) gebildet wird, wobei die strukturierte Platte (14) dazu bestimmt ist, einen ersten Teil (4) der Hybrid-Uhrenkomponente zu bilden, und Anordnen der mindestens einen Platte (14) über der im vorhergehenden Schritt gebildeten Form (13) aus Harz oder umgekehrt Anordnen mindestens einer Platte (14) eines ersten mikrobearbeitbaren Werkstoffs über der im vorhergehenden Schritt gebildeten Form (13) aus Harz und Strukturieren der mindestens einen Platte (14), so dass mindestens eine durchgehende Öffnung (15) der mindestens einen Platte (14) gebildet wird, wobei die mindestens eine durchgehende Öffnung (15) mindestens teilweise einem Bereich ohne Material der im vorhergehenden Schritt gebildeten Form (12) aus Harz überlagert ist;
- Bilden einer Form (17) aus Harz über der Platte (14), umfassend Bereiche ohne Material, die sich von der oberen Fläche (11) des Substrats (10) bis zur oberen Fläche des Stapels erstrecken, insbesondere an einer durchgehenden Öffnung (15) der Platte (14);
- Abscheiden eines Metalls oder einer Legierung durch Galvanoformung, so dass sich das Metall durch die durchgehende Öffnung (15) hindurch und auf den oberen und unteren Seiten der Platte (14) erstreckt, von der oberen Fläche (11) des Substrats (10) bis oberhalb der Platte (14), so dass sich das Metall in einem Stück erstreckt, das aus einem selben Galvanoformungsschritt resultiert, wobei das galvanogeformte Metall dazu bestimmt ist, einen zweiten Teil (8) der Hybrid-Uhrenkomponente zu bilden;
- Freigeben der Hybrid-Uhrenkomponente durch das Abziehen des Substrats (10);
- Beseitigen der Formen aus Harzen (13, 17) vor oder nach dem Abziehen des Substrats (10).

2. Verfahren zur Herstellung einer Hybrid-Uhrenkomponente nach dem vorhergehenden Anspruch, umfassend die folgenden ergänzenden Schritte:
- Bilden mindestens einer durchgehenden Öffnung (15) in der mindestens einen Platte (14), die einem Bereich ohne Material der Form (13) aus Harz überlagert ist, so dass die untere Seite der Platte (14) mindestens teilweise den Bereich ohne Material der Form (13) bedeckt; und
- Bilden einer Form (17) aus Harz über der Platte (14), die mindestens einen Teil der oberen Fläche der Platte (14) an einer durchgehenden Öffnung (15) der Platte (14) frei lässt.

3. Verfahren zur Herstellung einer Hybrid-Uhrenkomponente nach Anspruch 1 oder 2, umfassend einen Schritt des Bildens einer zweiten Schicht (19) aus Harz über der Form (13) aus Harz, die über der oberen Fläche (11) des Substrats (10) gebildet wurde, wobei die zweite Schicht (19) mindestens einen Positionierungszapfen bildet, der das nachträgliche Anordnen einer strukturierten Platte (14) ermöglicht, von der eine durchgehende Öffnung mit einem Positionierungszapfen zusammenwirkt, um ihren horizontalen Halt zu gewährleisten.

4. Verfahren zur Herstellung einer Hybrid-Uhrenkomponente nach einem der Ansprüche 1 bis 3, bei dem das Substrat (10) aus einer Siliciumplatte besteht, die eine Metallschicht beinhaltet, die insbesondere durch PVD-Abscheidung, durch Galvanoformung erhalten wird, oder aus einer Platte aus dotiertem Silicium oder aus einer Metallplatte.

5. Verfahren zur Herstellung einer Hybrid-Uhrenkomponente nach einem der vorhergehenden Ansprüche, bei dem der Schritt, der darin besteht, eine Form (13) aus Harz über der oberen Fläche (11) des Substrats (10) zu bilden, eine Form (13) bildet, deren Dicke der auf der unteren Seite (6) des ersten Teils (4) der Hybrid-Uhrenkomponente angeordneten Metallhöhe entspricht.

6. Verfahren zur Herstellung einer Hybrid-Uhrenkomponente nach einem der vorhergehenden Ansprüche, bei dem die Hybrid-Uhrenkomponente zu einer Gruppe gehört, die einen Zeiger, einen Anker, eine Unruh, ein Ritzel, ein Ankerrad, eine Spirale, eine Feder beinhaltet.

7. Verfahren zur Herstellung einer Hybrid-Uhrenkomponente nach einem der vorhergehenden Ansprüche, bei dem der Schritt, der darin besteht, ein Metall oder eine Legierung durch Galvanoformung abzuscheiden, einen zweiten Teil der Uhrenkomponente bildet, der eine zylindrische durchgehende Öffnung (9) umfasst, um einen Metalleinsatz zu bilden, der geeignet ist, eine Rotationsachse aufzunehmen, oder zum Einpressen der Hybrid-Uhrenkomponente.

8. Verfahren zur Herstellung einer Hybrid-Uhrenkomponente nach Anspruch 6 oder 7, bei dem die Uhrenkomponente ist:
- ein Zeiger mit Metalleinsatz zum Einpressen oder
- ein Zeiger mit Gegengewicht zum Auswuchten oder
- ein Anker mit Metalleinsatz zum Einpressen oder
- ein Anker mit Metallpaletten oder
- eine Unruh mit optimiertem Trägheit/Gewicht-Verhältnis oder
- ein Ankerrad mit Metalleinsatz oder
- ein Ankerrad mit flexibler Metallstruktur oder
- eine Spirale mit flexibler Metallrolle oder
- eine Spirale mit Spiralträger aus Metall oder
- eine Spirale mit Metalleinsätzen zum Einpressen auf einem Spiralträger oder
- eine Spirale mit Metalleinsatz zum Einpressen an der Rolle oder
- eine Feder mit dem funktionellen Teil aus Silicium und dem Befestigungsteil aus Metall.

## Claims

1. The process for manufacturing an hybrid timepiece component, comprising the following steps:
- providing a substrate (10), at least the upper surface (11) of which is conductive;
- forming a resist mold (13) on top of the upper surface (11) of the substrate (10), the mold (13) comprising at least one material-free zone on top of the substrate (10);
- structuring at least one wafer (14) of a first micromachinable material so as to form at least one through-opening (15) within the wafer (14), said structured wafer (14) being intended to form a first part (4) of the hybrid timepiece component and depositing the at least one wafer (14) on top of the resist mold (13) formed in the preceding step or conversely positioning at least one wafer (14) of a first micromachinable material on top of the resist mold (13) formed in the preceding step and structuring the at least one wafer (14) so as to form at least one through-opening (15) of the at least one wafer (14), the at least one through-opening (15) being at least partially superposed on a material-free zone of the resist mold (12) formed in the preceding step;
- forming a resist mold (17) on top of the wafer (14), comprising material-free zones that extend from the upper surface (11) of the substrate (10) to the upper surface of the stack, in particular at a through-opening (15) of the wafer (14);
- depositing a metal or an alloy by electroforming so that the metal extends through the through-opening (15) and over the two upper and lower faces of the wafer (14) from the upper surface (11) of the substrate (10) to the top of the wafer (14), so that the metal extends as a single piece resulting from one and the same electroforming step, the electroformed metal being intended to form a second part (8) of the hybrid timepiece component;
- releasing the hybrid timepiece component by the removal of the substrate (10);
- removing the resist molds (13, 17) before or after the removal of the substrate 10.

2. The process for manufacturing a hybrid timepiece component as claimed in the preceding claim, comprising the following additional steps:
- forming at least one through-opening (15) in the at least one wafer (14) superposed on a material-free zone of the resist mold (13) so that the lower face of the wafer (14) at least partially covers the material-free zone of the mold (13); and
- forming a resist mold (17) on top of the wafer (14) which leaves free at least a part of the upper surface of the wafer (14) at a through-opening (15) of the wafer (14).

3. The process for manufacturing a hybrid timepiece component as claimed in claim 1 or 2, comprising a step of forming a second resist layer (19) on top of the resist mold (13) formed on top of the upper surface (11) of the substrate (10) is comprised, the second layer (19) forming at least one positioning pin that enables the subsequent positioning of a structured wafer (14), a through-opening of which engages with a positioning pin in order to ensure the horizontal holding thereof.

4. The process for manufacturing a hybrid timepiece component as claimed in one of claims 1 to 3, wherein the substrate (10) consists of a silicon wafer comprising a metal layer, in particular obtained by PVD deposition or by electroforming, or of a doped silicon wafer or of a metal wafer.

5. The process for manufacturing a hybrid timepiece component as claimed in one of the preceding claims, wherein the step consisting in forming a resist mold (13) on top of the upper surface (11) of the substrate (10) forms a mold (13), the thickness of which corresponds to the height of metal positioned on the lower face (6) of the first part (4) of the hybrid timepiece component.

6. The process for manufacturing a hybrid timepiece component as claimed in one of the preceding claims, wherein the hybrid timepiece component is part of the group comprising a hand, a pallet, a balance, a pinion, a pallet wheel, a balance spring, a spring.

7. The process for manufacturing a hybrid timepiece component as claimed in one of the preceding claims, wherein the step of depositing a metal or an alloy by electroforming forms a second part of the timepiece component which comprises a cylindrical through-opening (9), in order to form a metal insert capable of receiving a rotating shaft or for driving in the hybrid timepiece component.

8. The process for manufacturing a hybrid timepiece component as claimed in claim 6 or 7, wherein the timepiece component is:
- a hand with metal insert for driving in, or
- a hand with counterweight for balancing, or
- a pallet with metal insert for driving in, or
- a pallet with metal pallet stones, or
- a balance with an optimized inertia/weight ratio, or
- a pallet wheel with metal inserts, or
- a pallet wheel with flexible metal structure, or
- a balance spring with flexible metal collet, or
- a balance spring with metal balance spring support, or
- a balance spring with metal inserts for driving in on a balance spring support, or
- a balance spring with metal insert for driving in to the collet, or
- a spring with the functional part made of silicon and the attachment part made of metal.
